(19) **Europäisches Patentamt**
**European Patent Office**
**Office européen des brevets**

(11) **EP 3 867 600 B1**

(12) **EUROPÄISCHE PATENTSCHRIFT**

(45) Veröffentlichungstag und Bekanntmachung des Hinweises auf die Patenterteilung:
**01.03.2023 Patentblatt 2023/09**

(21) Anmeldenummer: **19784107.5**

(22) Anmeldetag: **16.10.2019**

(51) Internationale Patentklassifikation (IPC):
**G06F 30/12** *(2020.01)* **G06T 19/00** *(2011.01)*
**G06K 9/00** *(2006.01)* **G01S 17/02** *(2006.01)*
**G01C 15/00** *(2006.01)*

(52) Gemeinsame Patentklassifikation (CPC):
**G01C 15/002; G01C 15/004; G06F 30/12;**
G06F 30/13

(86) Internationale Anmeldenummer:
**PCT/EP2019/078106**

(87) Internationale Veröffentlichungsnummer:
**WO 2020/083726 (30.04.2020 Gazette 2020/18)**

(54) **VERFAHREN ZUM REGISTRIEREN EINER TOTALSTATION IM BEZUGSSYSTEM EINES CAD-MODELLS**

METHOD FOR REGISTERING A TOTAL STATION IN THE REFERENCE SYSTEM OF A CAD MODEL

PROCÉDÉ D'ENREGISTREMENT D'UNE STATION TOTALE DANS LE SYSTÈME DE RÉFÉRENCE D'UN MODÈLE CAD

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.10.2018 EP 18020521**

(43) Veröffentlichungstag der Anmeldung:
**25.08.2021 Patentblatt 2021/34**

(73) Patentinhaber: **Hilti Aktiengesellschaft 9494 Schaan (LI)**

(72) Erfinder:
• **GLOOR, Thomas**
**9495 Triesen (LI)**
• **KLUG, Christoph**
**4432 Ernsthofen (AT)**
• **ARTH, Clemens**
**8111 Gratwein-Straßengel (AT)**

(74) Vertreter: **Hilti Aktiengesellschaft Corporate Intellectual Property Feldkircherstrasse 100 Postfach 333 9494 Schaan (LI)**

(56) Entgegenhaltungen:
**US-A1- 2013 096 873**

• **FREDERIC BOSCHE: "Plane-based registration of construction laser scans with 3D/4D building models", ADVANCED ENGINEERING INFORMATICS, Bd. 26, Nr. 1, 24. August 2011 (2011-08-24), Seiten 90-102, XP028339511, Amsterdam ISSN: 1474-0346, DOI: 10.1016/J.AEI.2011.08.009 [gefunden am 2011-08-30]**

## Beschreibung

Die Erfindung betrifft ein Verfahren zum Registrieren einer Totalstation im Bezugssystem eines CAD-Modells gemäß dem Oberbegriff des Anspruchs 1.

## Stand der Technik

Totalstationen sind Vermessungsgeräte, die über Winkel- und Distanzmesseinheiten verfügen und Winkel- und Distanzmessungen zu ausgewählten Zielobjekten erlauben. Die Winkel- und Distanzmesswerte werden im Bezugssystem der Totalstation gemessen und müssen für eine absolute Positionsbestimmung noch mit einem äußeren Bezugssystem verknüpft werden.

Bei bekannten Verfahren (siehe z. B. die Veröffentlichung FREDERIC BOSCHE, "Plane-based registration of construction laser scans with 3D/4D building models", ADVANCED ENGINEERING INFORMATICS, Bd. 26, Nr. 1, 24. August 2011 (2011-08-24), Seiten 90-102) zum Registrieren einer Totalstation in einem äußeren Bezugssystem werden Zielobjekte an bekannten Kontrollpunkten positioniert und die Koordinaten der Kontrollpunkte werden im Bezugssystem der Totalstation gemessen, die Koordinaten der Kontrollpunkte sind außerdem im äußeren Bezugssystem bekannt. Die Registrierung der Totalstation erfolgt mithilfe der Koordinaten der Kontrollpunkte im äußeren Bezugssystem und im Bezugssystem der Totalstation.

## Darstellung der Erfindung

Die Aufgabe der vorliegenden Erfindung besteht darin, die Registrierung einer Totalstation im Bezugssystem eines CAD-Modells dahingehend zu vereinfachen, dass die Registrierung der Totalstation ohne Kontrollpunkte mit bekannten Koordinaten möglich ist.

Diese Aufgabe wird bei dem eingangs genannten Verfahren erfindungsgemäß durch die Merkmale des unabhängigen Anspruchs 1 gelöst. Vorteilhafte Weiterbildungen sind in den abhängigen Ansprüchen angegeben.

Das Verfahren zum Registrieren einer Totalstation, die in einer Messumgebung mit einem oder mehreren Objekten aufgestellt ist, im Bezugssystem eines CAD-Modells, welches die Objekte der Messumgebung abbildet, durch eine Kontrolleinrichtung, umfasst erfindungsgemäß folgende Schritte:

- Auswahl von drei Flächen im CAD-Modell, wobei die Normalenvektoren der drei Flächen einen dreidimensionalen Raum aufspannen,
- Bestimmen einer ersten Ebenengleichung für eine erste Ebene, die eine erste Fläche der drei Flächen umfasst, einer zweiten Ebenengleichung für eine zweite Ebene, die eine zweite Fläche der drei Flächen umfasst, und einer dritten Ebenengleichung für eine dritte Ebene, die eine dritte Fläche der drei Flächen umfasst, im Bezugssystem des CAD-Modells durch die Kontrolleinrichtung,
- Ausrichten der Totalstation in der Messumgebung auf den Schnittpunkt der ersten, zweiten und dritten Ebene im CAD-Modell, wobei die Ausrichtung der Totalstation von der Kontrolleinrichtung als Startpose definiert wird,
- Rotieren der Totalstation um die Drehachse der Startpose und Ausführen von N verschiedenen Messungen während der Rotation der Totalstation, wobei bei jeder der N verschiedenen Messungen ein Horizontalwinkel von einer ersten Winkelmesseinheit, ein Vertikalwinkel von einer zweiten Winkelmesseinheit und eine Distanz von einer Distanzmesseinheit der Totalstation gemessen wird,
- Speichern von N verschiedenen Messpunkten mit Messkoordinaten, wobei die Messkoordinaten den Horizontalwinkel, den Vertikalwinkel und die Distanz umfassen,
- Zuordnen von K der N, $K \le N$ verschiedenen Messpunkte zur ersten Ebene, zur zweiten Ebene oder zur dritten Ebene, wobei die der ersten Ebene zugeordneten Messpunkte als erste Messpunkte, die der zweiten Ebene zugeordneten Messpunkte als zweite Messpunkte und die der dritten Ebene zugeordneten Messpunkte als dritte Messpunkte von der Kontrolleinrichtung definiert werden,
- Bestimmen einer ersten Funktionsgleichung für die ersten Messpunkte, einer zweiten Funktionsgleichung für die zweiten Messpunkte und einer dritten Funktionsgleichung für die dritten Messpunkte im Bezugssystem der Totalstation durch die Kontrolleinrichtung,
- Bestimmen einer Zuordnung zwischen der ersten, zweiten und dritten Ebenengleichung im Bezugssystem des CAD-Modells und der ersten, zweiten und dritten Funktionsgleichung im Bezugssystem der Totalstation durch die Kontrolleinrichtung und
- Speichern der Zuordnung als Transformationsfunktion zwischen dem Bezugssystem der Totalstation und dem Bezugssystem des CAD-Modells.

Die Registrierung der Totalstation im Bezugssystem des CAD-Modells erfolgt ohne Kontrollpunkte. Im CAD-Modell werden vom Bediener drei Flächen ausgewählt, die nicht-parallel sind und deren zugehörige Ebenen sich in einem Schnittpunkt schneiden. Die Auswahl der drei nicht-parallelen Flächen im CAD-Modell kann auch durch die Auswahl einer Ecke oder einer sonstigen Struktur, die drei nicht-parallele Flächen aufweist, erfolgen. Der Bediener richtet die Totalstation in einer Startposition und Startorientierung (Startpose) aus, in der die Distanzmesseinheit der Totalstation auf den Schnittpunkt der drei Ebenen ausgerichtet ist. Eine genaue Ausrichtung der Totalstation ist nicht erforderlich, da der Schnittpunkt selbst nicht vermessen wird.

Die Verknüpfung des Bezugssystems der Totalstation mit dem Bezugssystem des CAD-Modells erfolgt nicht über Kontrollpunkte und zwei Verteilungen, sondern über zwei Sätze von Ebenengleichungen. Die Ebenengleichungen im Bezugssystem des CAD-Modells können mit geringem Aufwand von der Kontrolleinrichtung aus dem CAD-Modell abgeleitet werden und die Ebenengleichungen im Bezugssystem der Totalstation werden mithilfe von Messpunkten bestimmt. Durch die Ausrichtung der Totalstation auf den Schnittpunkt der drei Ebenen und die anschließende Rotation der Totalstation um diese Drehachse ist sichergestellt, dass für jede der drei Ebenen Messpunkte erzeugt werden und mithilfe der Messpunkte entsprechende Ebenengleichungen im Bezugssystem der Totalstation bestimmt werden können.

Die Kontrolleinrichtung bestimmt aus den Ebenengleichungen im Bezugssystem des CAD-Modells und den Funktionsgleichungen im Bezugssystem der Totalstation mithilfe bekannter mathematischer oder numerischer Verfahren eine Zuordnung zwischen dem Bezugssystem der Totalstation und dem Bezugssystem des CAD-Modells und speichert diese Zuordnung als Transformationsfunktion. Die Transformationsfunktion zwischen dem Bezugssystem der Totalstation und dem Bezugssystem des CAD-Modells kann für verschiedene Koordinatentransformationen zwischen den Bezugssystemen genutzt werden.

In einer ersten bevorzugten Variante werden die Position und/oder die Orientierung der Totalstation im Bezugssystem des CAD-Modells bestimmt. Mithilfe der Transformationsfunktion können die Position und/oder die Orientierung der Totalstation in das Bezugssystem des CAD-Modells transformiert werden und die Pose (Position und Orientierung) der Totalstation ist im Bezugssystem des CAD-Modells bekannt.

In einer zweiten bevorzugten Variante werden Messkoordinaten, die mit der Totalstation im Bezugssystem der Totalstation gemessen wurden, in das Bezugssystem des CAD-Modells transformiert. Die Transformationsfunktion zwischen dem Bezugssystem der Totalstation und dem Bezugssystem des CAD-Modells kann genutzt werden, um Messkoordinaten in das CAD-Modell zu übertragen.

In einer dritten bevorzugten Variante werden Soll-Koordinaten, die im Bezugssystem des CAD-Modells bestimmt wurden, in das Bezugssystem der Totalstation transformiert. Die Transformationsfunktion zwischen dem Bezugssystem der Totalstation und dem Bezugssystem des CAD-Modells kann genutzt werden, um Soll-Koordinaten aus dem CAD-Modell in die Messumgebung zu übertragen. Beim Layout werden Koordinaten aus einem Plan (CAD-Modell) in die Messumgebung übertragen. Die Soll-Koordinaten können mithilfe der Transformationsfunktion in Winkelkoordinaten und Distanzkoordinaten für die Totalstation umgerechnet werden. Der Bediener nutzt ein reflektierendes Zielobjekt und wird mithilfe der Totalstation beim Auffinden der Koordinaten in der Messumgebung unterstützt.

## Ausführungsbeispiele

Ausführungsbeispiele der Erfindung werden nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematischer und/oder leicht verzerrter Form ausgeführt. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die allgemeine Idee der Erfindung ist nicht beschränkt auf die exakte Form oder das Detail der im Folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei gegebenen Bemessungsbereichen sollen auch innerhalb der genannten Grenzen liegende Werte als Grenzwerte offenbart und beliebig einsetzbar und beanspruchbar sein. Der Einfachheit halber sind nachfolgend für identische oder ähnliche Teile oder Teile mit identischer oder ähnlicher Funktion gleiche Bezugszeichen verwendet.

Es zeigen:

FIG. 1      eine Totalstation, die in einer Messumgebung aufgestellt und mit einer Kontrolleinrichtung verbunden ist;

FIGN. 2A, B      die Totalstation (FIG. 2A) und die Kontrolleinrichtung mit einem CAD-Modell (FIG. 2B) im Detail;

FIGN. 3A, B      das CAD-Modell der Objekte (FIG. 3A) und die Messumgebung 11 mit der Totalstation 10; und

FIG. 4      die Messumgebung mit N Messpunkten.

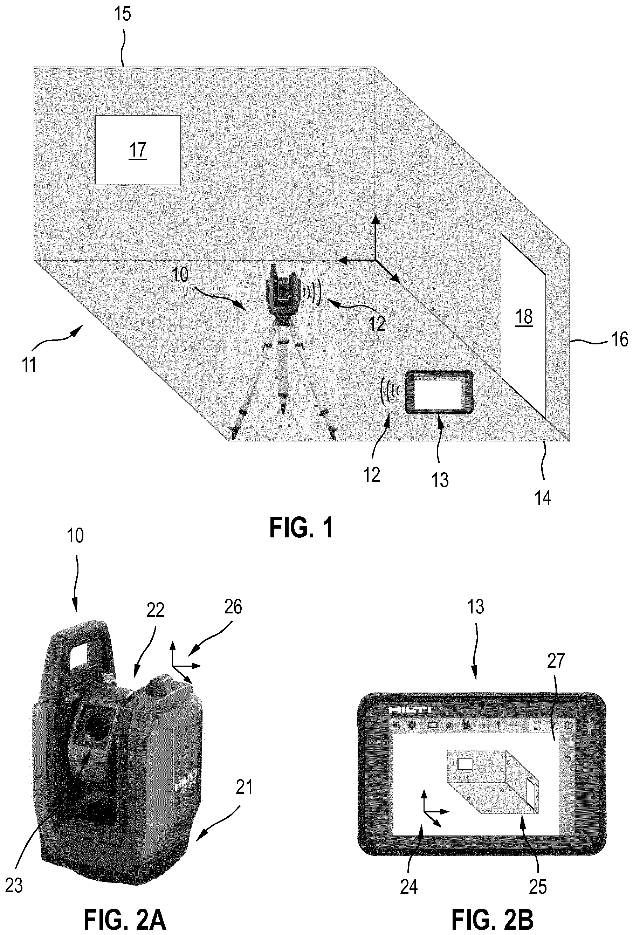

FIG. 1 zeigt eine Totalstation 10, die in einer Messumgebung 11 aufgestellt ist und über eine Kommunikationsverbindung 12 mit einer Kontrolleinrichtung 13 verbunden ist. Die Messumgebung 11 ist im Ausführungsbeispiel als Innenraum ausgebildet, der von einer Bodenfläche 14, einer Rückwand 15 und einer Seitenwand 16 begrenzt wird; die weiteren Begrenzungsflächen der Messumgebung 11 sind nicht dargestellt.

Die Messumgebung 11 weist mehrere Objekte auf. Zu den Objekten der Messumgebung 11 gehören die Bodenfläche 14, die Rückwand 15 und die Seitenwand 16 sowie eine Fensteraussparung 17 und eine Türaussparung 18. Die Objekte 14, 15, 16, 17, 18 der Messumgebung sind in einem CAD-Modell abgebildet.

FIG. 2A, B zeigen die Totalstation 10 (FIG. 2A) und die Kontrolleinrichtung 13 (FIG. 2B) der FIG. 1 im Detail. Die Totalstation 10 und die Kontrolleinrichtung 13 sind über die Kommunikationsverbindung 12 miteinander verbunden.

Die Totalstation 10 umfasst eine erste Winkelmesseinheit **21,** die einen Horizontalwinkel misst, eine zweite Winkelmesseinheit **22,** die einen Vertikalwinkel misst, und eine Distanzmesseinheit **23,** die eine Distanz misst. Um die Totalstation 10 zum Layouten einsetzen zu können, muss die Totalstation 10 im Bezugssystem **24** des CAD-Modells **25** registriert werden, d.h. die Transformationsfunktion zwischen dem Bezugssystem **26** der Totalstation 10 und dem Bezugssystem 24 des CAD-Modells 25 muss bestimmt werden.

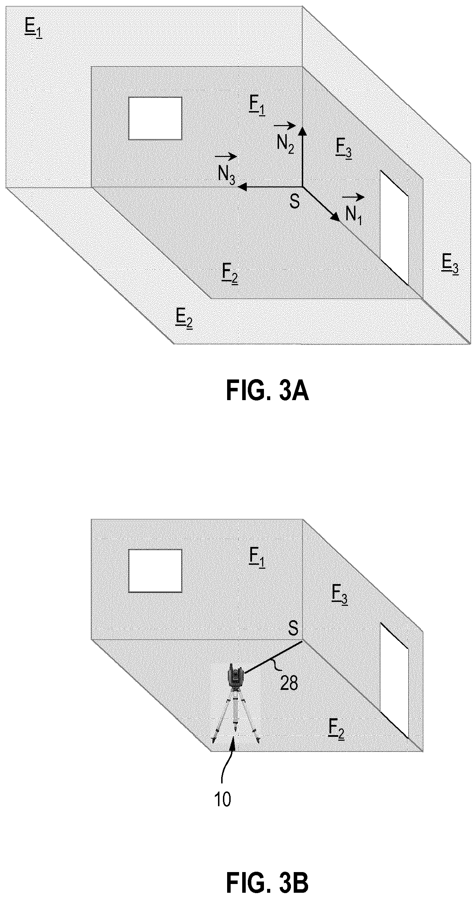

Die Durchführung des erfindungsgemäßen Verfahrens zur Registrierung der Totalstation 10 im Bezugssystem 24 des CAD-Modells 25 wird von der Kontrolleinrichtung 13 gesteuert. Das CAD-Modell 25 der Objekte ist in die Kontrolleinrichtung 13 geladen und wird auf einem Display **27** der Kontrolleinrichtung 13 angezeigt. **FIGN. 3A, B** zeigen das CAD-Modell 25 der Objekte (FIG. 3A) und die Messumgebung 11 mit der Totalstation 10 (FIG. 3B).

Der Bediener wählt im CAD-Modell 25 drei Flächen aus und markiert diese Flächen. Im Ausführungsbeispiel bildet die Oberfläche der Rückwand 15 eine erste Fläche **F$_1$,** die Oberfläche der Bodenfläche 14 eine zweite Fläche **F$_2$** und die Oberfläche der Seitenwand 16 eine dritte Fläche **F$_3$.** Für das erfindungsgemäße Verfahren ist wesentlich, dass die drei Flächen F$_1$, F$_2$, F$_3$ nicht-parallel zueinander angeordnet sind. Diese Bedingung wird mathematisch dadurch berücksichtigt, dass die Normalenvektoren der drei Flächen F$_1$, F$_2$, F$_3$ einen dreidimensionalen Raum aufspannen. Die erste Fläche F, ist durch einen ersten Normalenvektor $\vec{N}_1$ gekennzeichnet, der senkrecht auf der ersten Fläche F$_1$ steht, die zweite Fläche F$_2$ durch einen zweiten Normalenvektor $\vec{N}_2$, der senkrecht auf der zweiten Fläche F$_2$ steht, und die dritte Fläche F$_3$ durch einen dritten Normalenvektor $\vec{N}_3$, der senkrecht auf der dritten Fläche F$_3$ steht.

Die Kontrolleinrichtung 13 bestimmt eine erste Ebene **E$_1$,** die die erste Fläche F$_1$ umfasst, eine zweite Ebene **E$_2$,** die die zweite Fläche F$_2$ umfasst, und eine dritte Ebene **E$_3$,** die die dritte Fläche F$_3$ umfasst. Die Lage einer Ebene ist im dreidimensionalen Raum durch einen Punkt und die Angabe des Normalenvektors eindeutig bestimmt. Alternativ kann die Lage einer Ebene beispielsweise durch drei Punkte festgelegt werden. Die Kontrolleinrichtung 13 generiert eine erste Ebenengleichung für die erste Ebene E$_1$, eine zweite Ebenengleichung für die zweite Ebene E$_2$ und eine dritte Ebenengleichung für die dritte Ebene E$_3$.

Um die Totalstation 10 mit Hilfe des erfindungsgemäßen Verfahrens im Bezugssystem des CAD-Modells zu registrieren, wird die Totalstation 10 in der Messumgebung 11 auf den Schnittpunkt **S** der ersten, zweiten und dritten Ebene E$_1$, E$_2$, E$_3$ im CAD-Modell ausgerichtet (FIG. 3B). Diese Ausrichtung der Totalstation 10 wird von der Kontrolleinrichtung 13 als Startpose definiert. Die Startpose umfasst eine Startposition und eine Startorientierung. Die Totalstation 10 rotiert um die Startorientierung der Startpose als Drehachse **28** und führt während der Rotation N, N ∈ N verschiedene Messungen aus. Bei jeder Messung wird von der ersten Winkelmesseinheit 21 ein Horizontalwinkel, von der zweiten Winkelmesseinheit 22 ein Vertikalwinkel und von der Distanzmesseinheit 23 eine Distanz gemessen. Im Ausführungsbeispiel wird während der Rotation der Totalstation 10 eine Anzahl von N = 19 verschiedenen Messungen ausgeführt.

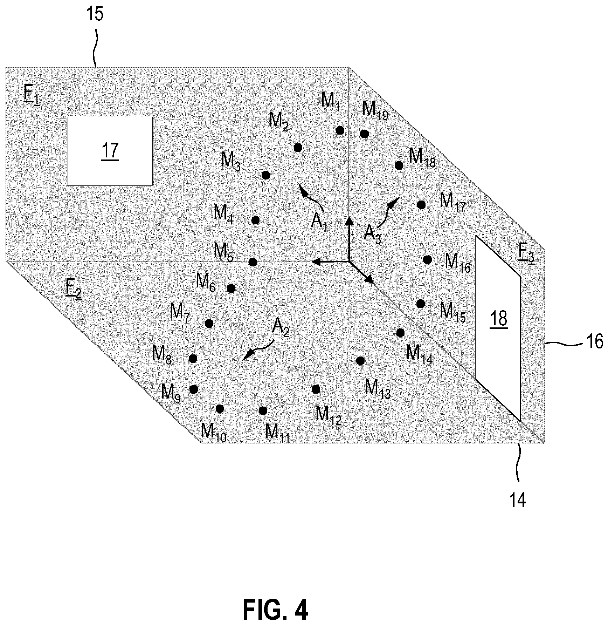

**FIG. 4** zeigt die N = 19 verschiedenen Messungen. Zu jeder Messung wird ein Messpunkt M$_i$, $i \in \mathbb{N}$ mit zugehörigen Messkoordinaten definiert, wobei die Messkoordinaten jeweils einen Horizontalwinkel, einen Vertikalwinkel und eine Distanz umfassen. Im nächsten Schritt werden die Messpunkte M$_i$ von der Kontrolleinrichtung 13 der ersten Ebene E$_1$, der zweiten Ebene E$_2$ oder der dritten Ebene E$_3$ zugeordnet. Die Messpunkte M$_1$ bis M$_4$ werden der ersten Ebene E$_1$ zugeordnet und als erste Messpunkte **A$_1$** definiert, die Messpunkte M$_6$ bis M$_{14}$ werden der zweiten Ebene E$_2$ zugeordnet und als zweite Messpunkte **A$_2$** definiert und die Messpunkte M$_{15}$ bis M$_{19}$ werden der dritten Ebene E$_3$ zugeordnet und als dritte Messpunkte **A$_3$** definiert. Der Messpunkt M$_5$ liegt auf der Schnittlinie zwischen der ersten Ebene E$_1$ und der zweiten Ebene E$_2$ und kann weder der ersten Ebene E$_1$ noch der zweiten Ebene E$_2$ eindeutig zugeordnet werden.

Nach der Zuordnung der Messpunkte M$_i$ zur ersten, zweiten oder dritten Ebene bestimmt die Kontrolleinrichtung 13 aus den ersten Messpunkten A$_1$ eine erste Funktionsgleichung für eine erste Ebene im Bezugssystem 26 der Totalstation 10, aus den zweiten Messpunkten A$_2$ eine zweite Funktionsgleichung für eine zweite Ebene im Bezugssystem 26 der Totalstation 10 und aus den dritten Messpunkten A$_3$ eine dritte Funktionsgleichung für eine dritte Ebene im Bezugssystem 26 der Totalstation 10. Die Genauigkeit, mit der die Kontrolleinrichtung 13 die Funktionsgleichungen (erste, zweite und dritte Funktionsgleichung) im Bezugssystem 26 der Totalstation 10 bestimmen kann, hängt ab von der Anzahl der jeweiligen Messpunkte M$_i$ und der Genauigkeit, mit die Messpunkte M$_i$ bestimmt wurden.

In der Kontrolleinrichtung 13 sind für die erste, zweite und dritte Ebene erste, zweite und dritte Ebenengleichungen im Bezugssystem 24 des CAD-Modells 25 sowie erste, zweite und dritte Funktionsgleichungen im Bezugssystem 26 der Totalstation 10 gespeichert. Die Kontrolleinrichtung 13 bestimmt aus den Ebenengleichungen im Bezugssystem 24 des CAD-Modells 25 und den Funktionsgleichungen im Bezugssystem 26 der Totalstation 10 mithilfe bekannter mathematischer oder numerischer Verfahren eine Zuordnung zwischen dem Bezugssystem 26 der Totalstation 10 und dem Bezugssystem 24 des CAD-Modells 25 und speichert diese Zuordnung als Transformationsfunktion.

Die Transformationsfunktion zwischen dem Bezugssystem 26 der Totalstation 10 und dem Bezugssystem 24 des CAD-Modells 25 kann für verschiedene Koordinatentransformationen zwischen den Bezugssystemen 24, 26 genutzt werden. Beispielsweise können Messkoordinaten, die mit der Totalstation 10 im Bezugssystem 26 der Totalstation 10 gemessen wurden, in das Bezugssystem 24 des CAD-Modells 25 transformiert, oder Soll-Koordinaten, die im Bezugssystem 24 des CAD-Modells 25 bestimmt wurden, können in das Bezugssystem 26 der Totalstation 10 transformiert.

**Patentansprüche**

1. Verfahren zum Registrieren einer Totalstation (10), die in einer Messumgebung (11) mit einem oder mehreren Objekten (14, 15, 16, 17, 18) aufgestellt ist, im Bezugssystem (24) eines CAD-Modells (25), welches die Objekte (14, 15, 16, 17, 18) der Messumgebung (11) abbildet, durch eine Kontrolleinrichtung (13), mit den Schritten:

   ▪ Auswahl von drei Flächen ($F_1$, $F_2$, $F_3$) im CAD-Modell (25), wobei die Normalenvektoren ($\vec{N}_1$, $\vec{N}_2$, $\vec{N}_3$) der drei Flächen ($F_1$, $F_2$, $F_3$) einen dreidimensionalen Raum aufspan-nen,
   ▪ Bestimmen einer ersten Ebenengleichung für eine erste Ebene ($E_1$), die eine erste Fläche ($F_1$) der drei Flächen ($F_1$, $F_2$, $F_3$) umfasst, einer zweiten Ebenengleichung für eine zweite Ebene ($E_2$), die eine zweite Fläche ($F_2$) der drei Flächen ($F_1$, $F_2$, $F_3$) umfasst, und einer dritten Ebenengleichung für eine dritte Ebene ($E_3$), die eine dritte Fläche ($F_3$) der drei Flächen ($F_1$, $F_2$, $F_3$) umfasst, im Bezugssystem (24) des CAD-Modells (25) durch die Kontrolleinrichtung (13),

   **dadurch gekennzeichnet, dass** es die folgenden Schritte umfasst:

   ▪ Ausrichten der Totalstation (10) in der Messumgebung (11) auf den Schnittpunkt (S) der ersten Ebene ($E_1$), zweiten Ebene ($E_2$) und dritten Ebene ($E_3$) im CAD-Modell (25), wobei die Ausrichtung der Totalstation (10) von der Kontrolleinrichtung (13) als Startpose definiert wird,
   ▪ Rotieren der Totalstation (10) um die Drehachse (28) der Startpose und Ausführen von N, N ∈ N verschiedenen Messungen während der Rotation der Totalstation (10), wobei bei jeder der N verschiedenen Messungen ein Horizontalwinkel von einer ersten Winkelmesseinheit (21), ein Vertikalwinkel von einer zweiten Winkelmesseinheit (22) und eine Distanz von einer Distanzmesseinheit (23) der Totalstation (10) gemessen wird,

   ▪ Speichern von N verschiedenen Messpunkten ($M_1$ - $M_{19}$) mit Messkoordinaten, wobei die Messkoordinaten den Horizontalwinkel, den Vertikalwinkel und die Distanz umfassen,
   ▪ Zuordnen von K der N, K ≤ N verschiedenen Messpunkte zur ersten Ebene ($E_1$), zur zweiten Ebene ($E_2$) oder zur dritten Ebene ($E_3$), wobei die der ersten Ebene ($E_1$) zugeordneten Messpunkte als erste Messpunkte ($A_1$), die der zweiten Ebene ($E_2$) zugeordneten Messpunkte als zweite Messpunkte ($A_2$) und die der dritten Ebene ($E_3$) zugeordneten Messpunkte als dritte Messpunkte ($A_3$) von der Kontrolleinrichtung (13) definiert werden,
   ▪ Bestimmen einer ersten Funktionsgleichung für die ersten Messpunkte ($A_1$), einer zweiten Funktionsgleichung für die zweiten Messpunkte ($A_2$) und einer dritten Funktionsgleichung für die dritten Messpunkte ($A_3$) im Bezugssystem (26) der Totalstation (10) durch die Kontrolleinrichtung (13),
   ▪ Bestimmen einer Zuordnung zwischen der ersten, zweiten und dritten Ebenengleichung im Bezugssystem (24) des CAD-Modells (25) und der ersten, zweiten und dritten Funktionsgleichung im Bezugssystem (26) der Totalstation (10) durch die Kontrolleinrichtung (13) und
   ▪ Speichern der Zuordnung als Transformationsfunktion zwischen dem Bezugssystem (26) der Totalstation (10) und dem Bezugssystem (24) des CAD-Modells (25).

2. Verfahren nach Anspruch 1, **dadurch gekennzeichnet, dass** die Position und/oder die Orientierung der Totalstation (10) im Bezugssystem (24) des CAD-Modells (25) bestimmt werden.

3. Verfahren nach Anspruch 1, **dadurch gekennzeichnet, dass** Messkoordinaten, die mit der Totalstation im Bezugssystem (26) der Totalstation (10) gemessen wurde, in das Bezugssystem (24) des CAD-Modells (25) transformiert werden.

4. Verfahren nach Anspruch 1, **dadurch gekennzeichnet, dass** Soll-Koordinaten, die im Bezugssystem (24) des CAD-Modells (25) bestimmt wurden, in das Bezugssystem (26) der Totalstation (10) transformiert werden.

**Claims**

1. Method for registering a total station (10), which is deployed in a measurement environment (11) with one or more objects (14, 15, 16, 17, 18), in the reference system (24) of a CAD model (25), which images the objects (14, 15, 16, 17, 18) of the measurement environment (11), by means of a control device (13), including the steps of:

- selecting three surfaces ($F_1$, $F_2$, $F_3$) in the CAD model (25), wherein the normal vectors ($\vec{N}_1$, $\vec{N}_2$, $\vec{N}_3$) of the three surfaces ($F_1$, $F_2$, $F_3$) span a three-dimensional space,
- determining a first plane equation for a first plane ($E_1$), which comprises a first surface ($F_1$) of the three surfaces ($F_1$, $F_2$, $F_3$), a second plane equation for a second plane ($E_2$), which comprises a second surface ($F_2$) of the three surfaces ($F_1$, $F_2$, $F_3$), and a third plane equation for a third plane ($E_3$), which comprises a third surface ($F_3$) of the three surfaces ($F_1$, $F_2$, $F_3$), in the reference system (24) of the CAD model (25) by means of the control device (13),

**characterized in that** the said method comprises the following steps:

- aligning the total station (10) in the measurement environment (11) on the point of intersection (S) of the first plane ($E_1$), second plane ($E_2$) and third plane ($E_3$) in the CAD model (25), wherein the alignment of the total station (10) is defined as start pose by the control device (13),
- rotating the total station (10) about the axis of rotation (28) of the start pose and carrying out N, $N \in \mathbb{N}$, different measurements during the rotation of the total station (10), wherein, in each of the N different measurements, a horizontal angle is measured by a first angle measuring unit (21), a vertical angle is measured by a second angle measuring unit (22) and a distance is measured by a distance measuring unit (23) of the total station (10),
- storing N different measured points ($M_1$ - $M_{19}$) with measured coordinates, wherein the measured coordinates comprise the horizontal angle, the vertical angle and the distance,
- assigning K of the N, $K \leq N$, different measured points to the first plane ($E_1$), to the second plane ($E_2$) or to the third plane ($E_3$), wherein the measured points assigned to the first plane ($E_1$) are defined as first measured points ($A_1$), the measured points assigned to the second plane ($E_2$) are defined as second measured points ($A_2$) and the measured points assigned to the third plane ($E_3$) are defined as third measured points ($A_3$), in each case by the control device (13),
- determining a first function equation for the first measured points ($A_1$), a second function equation for the second measured points ($A_2$) and a third function equation for the third measured points ($A_3$) in the reference system (26) of the total station (10) by means of the control device (13),
- determining a mapping between the first, second and third plane equation in the reference system (24) of the CAD model (25) and the first, second and third function equation in the reference system (26) of the total station (10) by means of the control device (13), and
- storing the mapping as a transformation function between the reference system (26) of the total station (10) and the reference system (24) of the CAD model (25).

2. Method according to Claim 1, **characterized in that** the position and/or the orientation of the total station (10) are determined in the reference system (24) of the CAD model (25).

3. Method according to Claim 1, **characterized in that** measured coordinates, which were measured with the total station in the reference system (26) of the total station (10), are transformed into the reference system (24) of the CAD model (25).

4. Method according to Claim 1, **characterized in that** intended coordinates, which were determined in the reference system (24) of the CAD model (25), are transformed into the reference system (26) of the total station (10).

**Revendications**

1. Procédé permettant d'enregistrer une station totale (10), qui est mise en place dans un environnement de mesure (11) avec un ou plusieurs objets (14, 15, 16, 17, 18), dans le référentiel (24) d'un modèle CAO (25) qui représente les objets (14, 15, 16, 17, 18) de l'environnement de mesure (11), à l'aide d'un dispositif de contrôle (13), comprenant les étapes consistant à :

- sélectionner trois surfaces ($F_1$, $F_2$, $F_3$) dans le modèle CAO (25), dans lequel les vecteurs normaux ($\vec{N}_1$, $\vec{N}_2$, $\vec{N}_3$) des trois surfaces ($F_1$, $F_2$, $F_3$) définissent un espace en trois dimensions,
- déterminer une première équation de plan pour un premier plan ($E_1$) qui comprend une première surface ($F_1$) des trois surfaces ($F_1$, $F_2$, $F_3$), une deuxième équation de plan pour un deuxième plan ($E_2$) qui comprend une deuxième surface ($F_2$) des trois surfaces ($F_1$, $F_2$, $F_3$), et une troisième équation de plan pour un troisième plan ($E_3$) qui comprend une troisième surface ($F_3$) des trois surfaces ($F_1$, $F_2$, $F_3$), dans le référentiel (24) du modèle CAO (25) à l'aide du dispositif de contrôle (13),

**caractérisé en ce qu'**il comprend les étapes suivantes consistant à :

- aligner la station totale (10) dans l'environnement de mesure (11) sur le point d'intersection (S) du premier plan ($E_1$), du deuxième plan ($E_2$) et du troisième plan ($E_3$) dans le modèle CAO (25), dans lequel l'alignement de la station totale (10) est défini par le dispositif de contrôle (13) comme un point de départ,

- faire tourner la station totale (10) autour de l'axe de rotation (28) du point de départ, et effectuer N, $N \in \mathbb{N}$, mesures différentes pendant la rotation de la station totale (10), dans lequel à chacune des N mesures différentes, un angle horizontal est mesuré par une première unité de mesure d'angle (21), un angle vertical est mesuré par une deuxième unité de mesure d'angle (22), et une distance est mesurée par une unité de mesure de distance (23) de la station totale (10),

- stocker N points de mesure différents ($M_1$ à $M_{19}$) avec des coordonnées de mesure, dans lequel les coordonnées de mesure comprennent l'angle horizontal, l'angle vertical et la distance,

- associer K points parmi les N, $K \leq N$, points de mesure différents au premier plan ($E_1$), au deuxième plan ($E_2$) ou au troisième plan ($E_3$), dans lequel les points de mesure associés au premier plan ($E_1$) sont définis par le dispositif de contrôle (13) comme des premiers points de mesure ($A_1$), les points de mesure associés au deuxième plan ($E_2$) sont définis comme des deuxièmes points de mesure ($A_2$), et les points de mesure associés au troisième plan ($E_3$) sont définis comme des troisièmes points de mesure ($A_3$),

- déterminer une première équation de fonction pour les premiers points de mesure ($A_1$), une deuxième équation de fonction pour les deuxièmes points de mesure ($A_2$) et une troisième équation de fonction pour les troisièmes points de mesure ($A_3$) dans le référentiel (26) de la station totale (10), à l'aide du dispositif de contrôle (13),

- déterminer une association entre la première, la deuxième et la troisième équation de plan dans le référentiel (24) du modèle CAO (25) et la première, la deuxième et la troisième équation de fonction dans le référentiel (26) de la station totale (10) à l'aide du dispositif de contrôle (13), et

- stocker l'association sous forme de fonction de transformation entre le référentiel (26) de la station totale (10) et le référentiel (24) du modèle CAO (25).

2. Procédé selon la revendication 1, **caractérisé en ce que** la position et/ou l'orientation de la station totale (10) sont déterminées dans le référentiel (24) du modèle CAO (25).

3. Procédé selon la revendication 1, **caractérisé en ce que** des coordonnées de mesure qui ont été mesurées par la station totale dans le référentiel (26) de la station totale (10) sont transformées dans le référentiel (24) du modèle CAO (25).

4. Procédé selon la revendication 1, **caractérisé en ce que** des coordonnées théoriques qui ont été déterminées dans le référentiel (24) du modèle CAO (25) sont transformées dans le référentiel (26) de la station totale (10).

**FIG. 1**

**FIG. 2A**

**FIG. 2B**

FIG. 3A

FIG. 3B

FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FREDERIC BOSCHE.** Plane-based registration of construction laser scans with 3D/4D building models. *ADVANCED ENGINEERING INFORMATICS,* 24. August 2011, vol. 26 (1), 90-102